# EUROPEAN PATENT APPLICATION

(11) **EP 1 017 099 A2**
(43) Date of publication of application: **05.07.2000**
(21) Application number: 99204445.3
(22) Date of filing: 21.12.1999
(51) Int. Cl.: H01L 23/495

(54) **Improvements in or relating to semiconductor devices**

(30) Priority: 31.12.1998 US 114431 P
(71) Applicant: Texas Instruments Incorporated, Dallas, Texas 75251 (US)
(72) Inventor: Zuniga, Edward R., Sherman, Texas 75092 (US); Ozawa, Toshiyuki, Hayami-gun, Oita Pref (JP)
(74) Representative: Holt, Michael

(57) **Abstract**

A leadframe for use with semiconductor circuits comprising a chip mount pad; a plurality of leadframe segments, separated from said mount pad by a gap; and a plurality of adhesive surfaces, positioned such that they provide attachment for bonding wires to be extended over said gap.

## Description

### FIELD OF THE INVENTION

The present invention is related in general to the field of semiconductor devices and processes and more specifically to a leadframe configuration and assembly method for ultra-long bonding wires.

### DESCRIPTION OF THE RELATED ART

The lead count of surface mount semiconductor devices has been increasing for many years, driven by the need for more power and signal input/output. At the same time, there has been a strong push for smaller outline and lower profile device packages, motivated by the requirement to conserve board space in assembly. These trends are conflicting and have resulted in ever smaller pitch of the package leads.

The majority of commercial semiconductor devices are encapsulated in a molded plastic package. While part of the leads of a leadframe remain outside the package for solder attachment to printed circuit boards, the other part is inside the package. Here, the leads become gradually narrower as they approach the chip mount pad. Narrower, closely spaced leads with small surface areas for attaching bonding wires make the wire bonding process much more difficult, resulting in the need to design the leads so that they terminate more and more distant from the chip mount pad in order to gain a somewhat wider lead surface area for wire bonding. As an unavoidable consequence, the bonding wires have to cross the resulting long distance from the chip on the mount pad to the tip of the inner leads, making the wires unwieldingly long. They develop a strong tendency to sag under their own weight (gold is the material of choice in almost all wire-bonded devices). In addition, long wires have an increased tendency to succumb to sidewise movement under the dynamic forces of the encapsulation molding process with the risk of eventual electrical short with a neighboring wire. Prior efforts to reduce the weight of the gold wire loop by reducing the wire diameter have been restricted by the unacceptable increase of electrical impedance. The use of wire materials with higher electrical conductivity, such as copper, is hampered by the difficult technology of forming reliable intermetallics between these wire materials, such as copper, and the aluminum metal almost universally used for the chip contact pads.

Consequently, in present technology, the bonding wire lengths in dual-in-line packages and quad-flat-pak packages is restricted to about 2.4 mm for conventional molding processes. When multiplunger molding can be used, the acceptable wire length in dual-in-line packages is about 3.0 mm, and in quad-flat-pak packages about 5.0 mm. Unfortunately, even these wire lengths are only about half of the length actually needed for advanced high lead-count semiconductor devices.

In the past, so-called "interposers" have been proposed as support points for overly long bonding wires. They do not protect against wire displacements in the molding process, since the wires are only loosely and passively laid down, cost extra money for material and design, and sometimes introduce new reliability hazards.

An urgent need has therefore arisen for a low-cost, reliable mass production system and method providing the manufacture of long bonding wires of low electrical impedance without the risk of wire sweep and eventual electrical short. The system should provide the opportunity to increase the number of chip inputs/outputs by permitting closer wire proximity and within the constraints of existing wire capillary and bonding equipment technologies. The system and method should be flexible enough to be applied to different semiconductor product families and a wide spectrum of design, material and process variations, and should achieve improvements toward the goal of small outline and low profile packages, as well as toward the goals of improved process yield and device reliability. Preferably, these innovations should be accomplished using the installed equipment base so that no investment in new manufacturing machines is needed.

### SUMMARY OF THE INVENTION

According to the teachings of the present application, very long and low looping bonding wires extending over the gap between an IC chip and leadframe segments can be fabricated by anchoring the wires on adhesive surfaces positioned between the end points of the wires. Unintentional sagging of long wires under their own weight, sensitivity of long wires to sidewise displacements, and wire loops forming high arcs are thus avoided.

The present invention is related to high density ICs, especially those having high numbers of input/outputs, or contact pads, and also to devices requiring small package outlines and low profiles. These ICs can be found in many semiconductor device families such as standard linear and logic products, processors, digital and analog devices, high frequency and high power devices, and both large and small area chip categories. The disclosed teachings propose solution that helps to alleviate the space constraints in continually shrinking applications such as cellular communications, pagers, hard disk drives, laptop computers and medical instrumentation.

The disclosed teachings propose solution that utilize the materials, thicknesses and basic processing steps commonly practiced in wire bonding technology. However, the process is modified such that it enables the uncomplicated formation of anchor points of very long bonding wires. The bonding wires are anchored on predetermined adhesive surface areas of thin polymer layers attached to the leadframe. No extra curing of these polymer layers at elevated temperatures is required.

The teachings of the present application propose a process for reducing the bonding pad pitch on ICs without simultaneously requiring extra-fine pitch of the inner lead segments of leadframes. This is achieved by teaching the methodology to anchor ultra-long bonding wires at least on adhesive surfaces so that the wire can reliably extend over the wide gap between the chip and the tip of the inner lead segments.

The teachings of the present application further propose a method and system for assembling low-profile devices, resulting in very thin molded packages.

The teachings of the present application yet further propose a process that substantially eliminates the wire displacement during the transfer molding process of device encapsulation.

The teachings of the present application yet furhter propose a process that increases assembly yield by eliminating bonding wire damage due to handling, a common problem in manufacturing operations.

The teachings of the present application yet further propose a process that introduces assembly concepts for high lead count, thin profile packages which are flexible so that they can be applied to many families of semiconductor IC products, and are general so that they can be applied to several future generations of products.

The teachings of the present application yet further proposes a low-cost, high-speed process for fabrication with minimum movement of parts and product in the equipment, and reach these goals while minimizing the cost of equipment changes and new capital investment and using the installed fabrication equipment base.

These advantages over the prior art have been achieved by the teachings of the application concerning design concepts and methods suitable for mass production. Various modifications have been successfully employed to satisfy different selections of product geometries and materials.

In a first group of proposed embodiments of the invention, leadframes are produced with areas of polymer layers having adhesive surfaces. In one variation of this embodiment, these areas may be located on an enlarged chip mount pad, when such enlargement is compatible with the device design.

In another variation of this embodiment, the adhesive surface area is an extension of the polymer film which is used for supporting the inner lead tips of the leadframe. Such supporting polymer films are frequently employed to keep the tips of the inner leads steady during stitch bonding of the wires.

In yet another variation of this embodiment, the adhesive surface area is positioned on the heat sink of a thermally enhanced package, at some distance between the chip mount pad and the tips of the inner leads of the leadframe.

In a second group of proposed embodiments, bonding wires, connecting the IC chip with the inner leads of the leadframe, are anchored on the adhesive surfaces of polymer layers placed on portions of the leadframe. In one variation of this embodiment, such anchoring of the wire is performed only a single time for each wire, in another variation of this embodiment, such anchoring is performed twice or more often for each wire.

In another proposed embodiment, the process step of anchoring a bonding wire is performed individually for each wire by the bonding capillary after each wire has been attached through its ball and stitch bonding operations. In yet another embodiment, the process step of anchoring is performed on all wires simultaneously as a batch process, after all wires have been connected. A clamping tool, broader than a typical capillary tip, is used in a softly performed process step.

In all proposed embodiments, control of the wire lengths is implemented in order to provide sufficient lengths for the additional wire bendings required in the anchoring process.

### BRIEF DESCRIPTION OF THE DRAWINGS

The present invention will now be further described, by way of example, with reference to the accompanying drawings in which:
FIG. 1 is a schematic and simplified cross sectional view of a bonding wire connecting the IC chip and the inner lead of the leadframe in the known technology.
FIG. 2 is a schematic and simplified cross sectional view of a first proposed embodiment.
FIG. 3 is a schematic and simplified cross sectional view of a second proposed embodiment.
FIG. 4 is a schematic and simplified cross sectional view of a third proposed embodiment.
FIG. 5 is a schematic and simplified cross sectional view of a fourth proposed embodiment.
FIGs. 6A and 6B are schematic and simplified cross sectional views of one proposed embodiment, illustrating a sequence of process steps.
FIGs. 7A and 7B are schematic and simplified cross sectional views of another proposed embodiment, illustrating a sequence of process steps.

### DETAILED DESCRIPTION OF THE PREFERRED EMBODIMENTS

The present teachings are related to integrated circuit (IC) assembly and packages needing ultra-long bonding wires and frequently having both a small outline and a low profile. As defined herein, the term "outline" relates to the overall width and length of, for example, the entire IC package. The outline of the IC package is also referred to as the footprint of the IC package, because it defines the surface area on a motherboard that the IC package will occupy. Outline will be measured in, for example, square millimeters. As defined herein, the term "profile" refers to thickness or height of the IC package. The profile will be measured in, for example, millimeters.

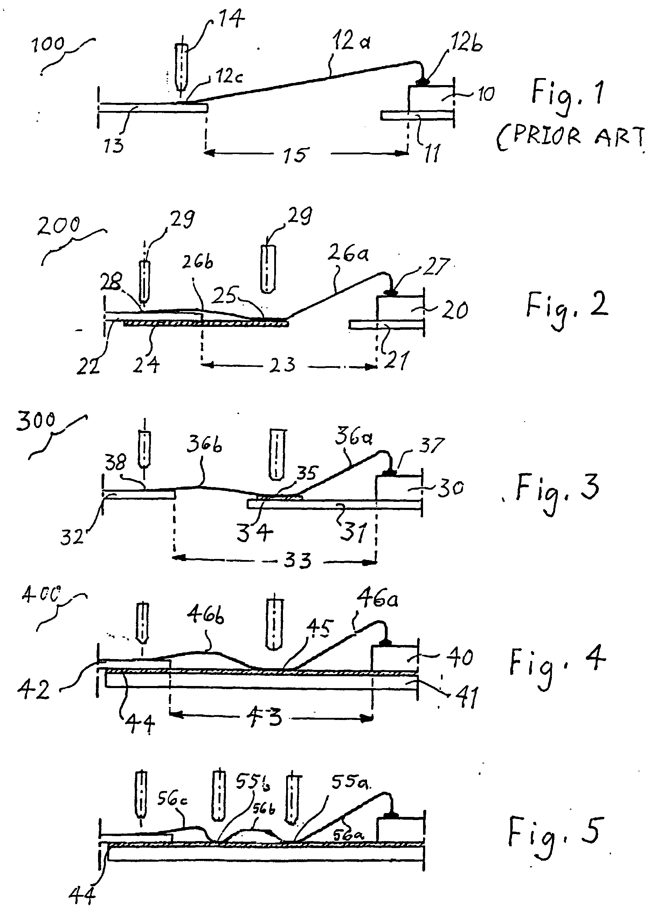

The impact of the advances proposed by the present teachings can be most easily appreciated by highlighting the shortcomings of the known technology. FIG. 1 depicts an assembly, generally designated 100, of a semiconductor IC chip 10 onto a leadframe, as performed in known technology. The chip 10 is attached to chip mount pad 11 of the leadframe and connected by bonding wire 12a to the tip of the inner lead 13 of the leadframe. Bonding wire 12a forms a ball 12b on the chip contact pad (in other devices, a wedge bond may be used) and a stitch bond 12c on the lead tip. The bonding capillary 14 is shown after wire break and lift-off from the stitch-forming process.

Typically, the semiconductor chip is made of silicon and the bonding wire of gold, diameter about 25 µm. The ball 12b forms reliable intermetallic layers with aluminum commonly used as chip contact pad metallization. In contrast, the stitch 12c is formed by metallic interdiffusion between the wire material (typically gold) and the metal surface of the leadframe segment (typically silver spot). For reliable interdiffusion at the stitch bond, sufficient contact area is required in addition to elevated temperature (such as 175 to 250° C) and sufficient contact strength. Sufficient contact area, in turn, is determined by the diameter of the capillary tip and the minimum width of the inner leads of the leadframe.

For reasons of easy and cost-effective manufacturing, it has been common practice to manufacture single piece leadframes from thin sheets of metal such as copper. A typical thickness range is 120 to 250 µm. The desired shape of the leadframe is etched or stamped from this original sheet. In this manner, an individual segment, or lead, of the leadframe takes the form of a thin metallic strip with its particular geometric shape determined by the design. For most purposes, the length of a typical segment is considerably longer than its width. For reasons of aspect ratio in manufacturing, the minimum width of the narrowest segment cannot be substantially smaller than the thickness of the leadframe starting material.

This minimum width of the leads determines the smallest lead pitch manufacturable; it is about 130 µm. Consequently, whenever high lead counts have to be accommodated for high numbers of IC inputs/output terminals, the distance or gap (designated 15 in FIG. 1) between the tip of the inner leads and the IC chip has to increase. For instance, newer device design call for about 8.0 to 10.0 mm. But the span, over which the bonding wire 12a can extend in known technology, is limited to about 2.4 mm using conventional molding technology, and 3.0 mm in dual-in-line packages and between about 4.0 and 5.0 mm in quad-flat-pak packages using multiplunger molding technology.

The present teachings propose a solution that resolves this dilemma using a number of innovative leadframe designs and wire bonding process options.

In FIG. 2, a first illustrative embodiment, generally designated 200, is schematically shown. The semiconductor IC chip 20 (silicon, silicon germanium, gallium arsenide, or any other semiconductor material used in manufacturing) is attached to chip mount pad 21 of the leadframe (copper, copper alloys, iron-nickel alloys, or invar). The inner lead 22 is stamped (or etched) from the same original metal sheet (thickness range about 120 to 250 µm) as chip mount pad 21. The distance, or gap, 23 between inner lead 22 and chip 20 is about 5.9 mm in dual-in-line packages, and about 8.0 to 10.0 mm in quad-flat-pak packages. The inner leads 22 have a lead pitch of about 130 µm and are supported by stabilizing polymer film 24. It is made of thermoplastic material requiring low curing temperature (about 175°C, the typical polymerization temperature of commonly used molding compounds). Preferred materials are Kapton or Upilex, with adhesive areas on both surfaces. Film 24 is attached to the leads 22 and has an adhesive surface in an area 25 where a bonding wire is to be attached.

In FIG. 2, the bonding wire consists of the wire length 26a and 26b, the ball bond 27, and the stitch bond 28. In a preferred embodiment, standard round wire of diameter between about 18 and 33 µm is used, although the wire should preferably be between 20 to 25 µm. For bonding to aluminum pads, the wire consists of gold, with optional very small contents of beryllium, copper, palladium, iron, silver, calcium or magnesium (which are sometimes employed to control the heat-affected wire zone in ball formation, which would be mechanically weak for bending or other deformation stresses. For bonding to copper pads, the wire consists of copper or gold of comparable diameter.

The wire bonding process begins by positioning the semiconductor chip on a heated pedestal to raise the temperature to between 150 and 300°C. The wire is strung through capillary 29. At the tip of the wire, a free air ball is created using either a flame or a spark technique. The ball has a typical diameter from about 1.2 to 1.6 wire diameters. The capillary is moved toward the chip bonding pad and the ball is pressed against the metallization of the pad. For pads of aluminum, a combination of compression force and ultrasonic energy creates the formation of gold-aluminum intermetallics and thus a strong metallurgical bond. At time of bonding, the temperature usually ranges from 150 to 270° C. In the case of copper wire on copper pad, only metal interdiffusion takes place in order to generate the strong weld. Alternatively, wedge bonding can be employed.

The length and shape of the wire loops 26a and 26b can be tightly controlled by computerized bonders such as bonder 8020 by Kulicke & Soffa, Willow Grove, PA, USA, or the ABACUS SA by Texas Instruments, Dallas, TX, USA. Moving the capillary in a predetermined and computer-controlled manner through the air will create a wire looping of exactly defined shape and length. For instance, with recent technical advances, rounded, trapezoidal, linear and customized loop paths can be formed. Consequently, shapes such as loop paths 26a and 26b in FIG. 2 can be created.

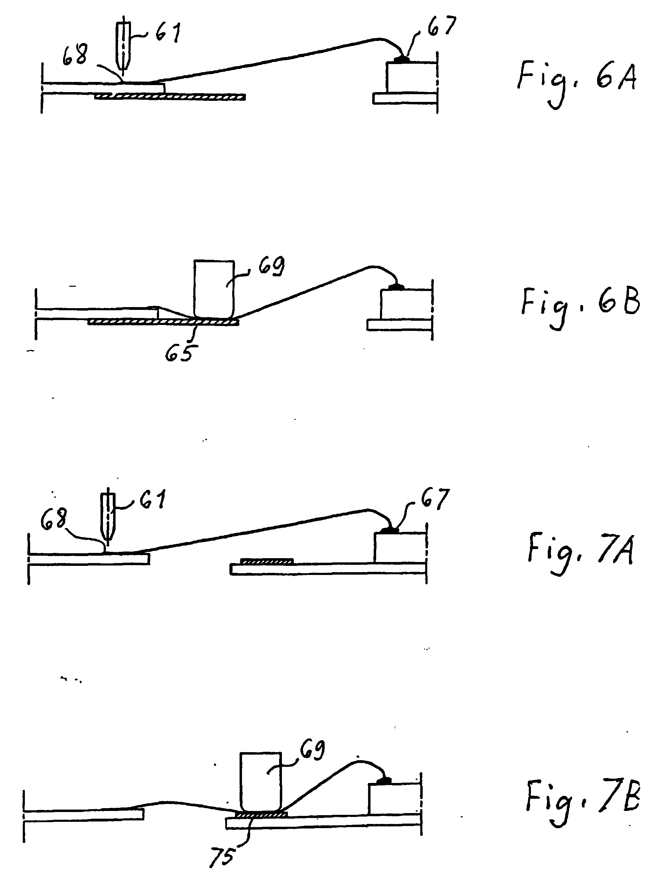

Over the adhesive surface 25 of polymer film 24, the capillary is lowered to bring the wire in contact with the adhesive surface. No ultrasonic power or compression is turned on; the wire is only gently pressed onto the adhesive surface. Afterwards, the capillary is lifted again. (An alternative batch-processing technique is described in conjunction with FIGs. 6B and 7B).

Finally, the capillary 29 reaches the lead tip at the predetermined area 28 in FIG. 2. The lead tip has a silver spot over copper, or a surface of gold, nickel or palladium. The capillary is lowered to touch the lead; with the imprint of the capillary, a metallurgical stitch bond is formed, and the wire is broken off to release capillary 29. Stitch contact are small yet reliable; the lateral dimension of the stitch imprint is about 1.5 to 3 times the wire diameter (its exact shape depends on the shape of the capillary used, such as capillary wall thickness and capillary footprint).

The anchoring of the bonding wire on adhesive surface 25 allows the formation of two wire spans 26a and 26b of approximately equal lengths of, for example, about 5.0mm. At these lengths, even gold wire of 25µm diameter will not sag under its own weight, nor does the wire exhibit sidewise displacement during the package molding process ("wire sweep").

FIG. 3 illustrates another illustrative embodiment, that is generally designated 300. Chip mount pad 31 is substantially extended. In the proximity of its edge, it has polymer film 34 attached, with an adhesive surface 35 for the attachment of the bonding wire. Adhesive surface 35 is positioned so that the gap 33 between the edge of lead 32 and the IC chip 30 is approximately cut in half. When the bonding wire is attached to adhesive surface 35, its looping span to extend over the gap 33 is divided into two approximately equal halves 36a and 36b. Thus, the wire has been provided with an anchoring place between ball bond 37 and stitch bond 38, with the same beneficial results for accommodating increased wire length as described in FIG. 2.

FIG. 4 illustrates another illustrative embodiment, that is generally designated 400. In thermally enhanced packages, the heat-producing chip 40 is backed up by a heat-dissipating piece of metal (usually copper, called "heat slug"). It is applied in various sizes. The device 400 shows an example of a heat slug which is merged with the chip mount pad and extending to the inner lead segments 42 of the leadframe. An insulating polymer layer 44 has adhesive surfaces, at least in selected areas, which provide attachment of the heat slug 41 to the chip 40 as well as to the leads 42. Preferred materials for polymer layer 44 are Kapton or Upilex.

An additional adhesive area 45 of polymer layer 44 provides an adhesive surface for anchoring the bonding wire connecting chip 40 to lead 42. By anchoring the bonding wire to the adhesive surface 45, two wire spans 46a and 46b are created. They provide stability to the bonding wire, eliminate sensitivity to wire displacement in the package molding process, and permit successful wire extension across gap 43 between the edge of chip 40 and the tip of lead 42. Analogous to embodiment 300, the embodiment 400 provides a reliable solution to accommodate wire length of about 10 mm. By way of example, each span 46a and 46b may measure about 5 mm.

FIG. 5 illustrates a variation of the embodiment 400. Polymer layer 44 provides two adhesive surface areas 55a and 55b where the bonding wire can be attached. In this case, three wire spans 56a, 56b, and 56c are created. They provide even stronger stability to the bonding wire, and permit wire length significantly beyond 10 mm.

In FIGs. 6A and 6B, and FIGs. 7A and 7B, two embodiments are illustrated that use a batch process for the bonding wire attachments to the adhesive surfaces described in embodiments 200 and 300, respectively. The process is divided into two phases. The first phase is shown in FIG. 6A and FIG. 7A, respectively. The capillary 67 completes the bonding process for ball attachment 67 and stitch attachment 68. In the computer-controlled wire extension process, sufficient wire length is provided to permit attachment tool 69 (see FIGs. 6B and 7B, respectively) to complete the attachment of the bonding wire to adhesive surfaces 65 and 75, respectively. Analogous to embodiments 200 and 300, two wire spans are created in FIGs. 6B and 7B, respectively, which provide stability and reliability to ultra-long bonding wires.

After the wire attachment process, any of the package molding processes can be performed which are installed in mass production factories: Conventional transfer molding, multi-plunger molding, or pre-packaged product ("3P") molding. Based on the system and method of the present teachings, even ultra-long bonding wires will not exhibit sensitivity to wire displacement (wire sweep).

While the present invention has been described in reference to illustrative embodiments, this description is not intended to be construed in a limiting sense. Various modifications and combinations of the illustrative embodiments, as well as other embodiments of the invention, will be apparent to persons skilled in the art upon reference to the description.

## Claims

1. A leadframe for use with semiconductor circuits comprising:
a chip mount pad;
a plurality of leadframe segments, separated from a mount pad by a gap; and
a plurality of adhesive surfaces, positioned such that they provide an area for attachment of bonding wires to be extended over said gap.

2. The leadframe according to Claim 1, wherein said adhesive surfaces are formed from polymer layers having two adhesive areas, a first area adhesive being attached to said leadframe, and a second adhesive area being arranged for attaching a bonding wire thereto.

3. The leadframe according to Claim 2, wherein said polymer layers are formed from thermoplastic material requiring low curing temperatures.

4. The leadframe according to any preceding Claim, wherein said adhesive surfaces are disposed on said mount pad.

5. The leadframe according to any preceding Claim, wherein said adhesive surfaces are disposed in conjunction with said leadframe segments.

6. The leadframe according to any preceding Claim, wherein said adhesive surfaces are disposed on a thermally enhancing, mechanically supportive portion of said leadframe.

7. The leadframe according to Claim 6 wherein said thermally enhancing, mechanically supportive portion of said leadframe comprises a metallic heat slug.

8. A semiconductor device comprising:
a leadframe having a chip mount pad, a plurality of leadframe segments separated from said mount pad by a gap, and a plurality of adhesive surfaces;
an integrated circuit chip attached to said chip mount pad; at least one bonding wire connecting said chip with at least one of said leadframe segments and extending over said gap;
said at least one bonding wire attached to at least one of said adhesive surfaces, thereby anchoring said wire; and
a package enclosing at least a portion of said leadframe segments, said circuit chip, said at least one bonding wire, and at least a portion of said chip mount pad.

9. The semiconductor device according to Claim 8 wherein said at least one bonding wire is attached to an adhesive area disposed on said mount pad.

10. The semiconductor device according to Claim 8 or Claim 9, wherein said at least one bonding wire is attached to an adhesive area disposed in conjunction with one of said leadframe segments.

11. The semiconductor device according to any of Claims 8 to 10, wherein said at least one bonding wire is attached to an adhesive area disposed on a thermally enhancing, mechanically supportive portion of said leadframe.

12. The semiconductor device according to any of Claims 8 to 11, wherein said at least one bonding wire is attached to two of said adhesive surfaces.

13. A method for the fabrication of a semiconductor device comprising:
a leadframe having pad, a plurality of leadframe segments separated from said mount pad by a gap, and a plurality of adhesive surfaces;
attaching an integrated circuit chip to a chip mount pad of a leadframe having pad, a plurality of leadframe segments separated from said mount pad by a gap, and a plurality of adhesive surfaces;
connecting said chip to at least one of said leadframe segments by extending at least one bonding wire over said gap; attaching said at least one bonding wire to at least one of said adhesive surfaces; and
enclosing at least a portion of said leadframe segments, said circuit chip, said at least one bonding wire, and at least a portion of said chip mount pad in a package.

14. The method according to Claim 13, wherein said step of attaching said at least one bonding wire to said at least one adhesive surface comprises the steps of:
moving and bending said bonding wire towards said adhesive surface; and
gently pressing said wire onto said adhesive surface.

15. The method according to Claim 14, further comprising:
performing said moving and bending step using the bonding capillary.

16. The method according to Claim 14, further comprising:
performing said moving and bending step using an attachment tool.

17. The method according to any of Claims 13 to 16, further comprising:
performing the step of attaching said at least one bonding wire to an adhesive surface at least twice sequentially.

18. The method according to any of Claims 14 to 17, further comprising:
controlling the wire length and wire path to provide sufficient length to permit said moving and bending step.
